# EUROPEAN PATENT APPLICATION

(11) **EP 4 733 863 A1**
(43) Date of publication of application: **29.04.2026**
(21) Application number: 24854276.3
(22) Date of filing: 11.06.2024
(51) Int. Cl.: G04G 17/04, G04G 17/08, G06F 1/16

(54) **DISPLAY HAVING CURVED SHAPE AND ELECTRONIC DEVICE COMPRISING SAME**

(30) Priority: 16.08.2023 KR 20230107285; 08.09.2023 KR 20230119901
(71) Applicant: Samsung Electronics Co., Ltd., Suwon-si, Gyeonggi-do 16677 (KR)
(72) Inventor: CHOI, Seungyeop, Suwon-si, Gyeonggi-do 16677 (KR); KIM, Kwangtai, Suwon-si, Gyeonggi-do 16677 (KR); CHOI, Sungdae, Suwon-si, Gyeonggi-do 16677 (KR)
(74) Representative: Gulde & Partner
(86) International application number: PCT/KR2024/007958
(87) International publication number: WO 2025/037723

(57) **Abstract**

A display is provided. According to an embodiment, the display comprises: a first display unit; a second display unit; a plurality of pixels which are disposed in the first display unit and the second display unit and spaced apart from each other; and a plurality of connection parts which connect the plurality of pixels to each other, wherein: the plurality of pixels comprise a first pixel and a second pixel each of which has a first size, and a third pixel and a fourth pixel each of which has a second size smaller than the first size; and the plurality of connection parts comprise at least one first connection part which has a first length and connects the first pixel and the second pixel to each other, and a plurality of second connection parts which have a second length greater than the first length, the number of which is greater than the number of the at least one first connection part, and which connect the third pixel and the fourth pixel to each other.

## Description

### [Technical Field]

The present disclosure relates to a display having a curved shape and an electronic device including the same.

### [Background Art]

An electronic device may include a display for providing visual information to a user. As a form factor of the electronic device is diversified, the display may have various shapes. For example, the display may be disposed on the electronic device in a state of having a curved shape to have a curvature.

### [Disclosure]

### [Technical Solution]

A display is provided. According to an embodiment, the display may comprise a first display part. According to an embodiment, the display may comprise a second display part having a curved shape to have a curvature greater than the first display part. According to an embodiment, the display may comprise a plurality of pixels, spaced apart from each other, configured to emit light, and disposed in the first display part and the second display part. According to an embodiment, the display may comprise a plurality of connecting parts connecting the plurality of pixels. According to an embodiment, the plurality of pixels may include a first pixel and a second pixel disposed in the first display part and respectively having a first size. According to an embodiment, it may include a third pixel and a fourth pixel disposed in the second display part and respectively having a second size smaller than the first size. According to an embodiment, the plurality of connecting parts may include at least one first connecting part having a first length and connecting the first pixel and the second pixel. According to an embodiment, it may include a plurality of second connecting parts having a second length longer than the first length, having the number bigger than the number of the at least one first connecting part, and connecting the third pixel and the fourth pixel.

An electronic device is provided. According to an embodiment, the electronic device may comprise a frame. According to an embodiment, the electronic device may comprise a display disposed on the frame. According to an embodiment, the display may include a first display part. According to an embodiment, the display may include a second display part having a curved shape to have a curvature greater than the first display part. According to an embodiment, the display may include a plurality of pixels respectively configured to emit light, disposed in the first display part and the second display part, and spaced apart from each other. According to an embodiment, the display may include a plurality of connecting parts connecting the plurality of pixels and having a curved shape. According to an embodiment, the plurality of pixels may include a first pixel and a second pixels disposed in the first display part and respectively having a first size. According to an embodiment, the plurality of pixels may include a third pixel and a fourth pixel disposed in the second display part and respectively having a second size smaller than the first size. According to an embodiment, the plurality of connecting parts may include at least one first connecting part having a first length and connecting the first pixel and the second pixel. According to an embodiment, the plurality of connecting parts may include a plurality of second connecting parts having a second length longer than the first length, connecting the third pixel and the fourth pixel.

### [Description of the Drawings]

FIG. 1 is a block diagram of an electronic device in a network environment according to various embodiments.
FIG. 2A is a perspective view of an exemplary electronic device according to an embodiment.
FIG. 2B is a perspective view of an exemplary electronic device according to an embodiment.
FIG. 3 is an exploded perspective view of an exemplary electronic device according to an embodiment.
FIG. 4A is a perspective view indicating an example in which a display is disposed on an exemplary electronic device according to an embodiment.
FIG. 4B is a cross-sectional view illustrating an example of an exemplary display cut along line A-A' of FIG. 4A according to an embodiment.
FIG. 5A is a top view enlarging a portion of an exemplary display according to an embodiment.
FIG. 5B is an enlarged view enlarging an exemplary first pixel and third pixel according to an embodiment.
FIG. 6 illustrates an exemplary electronic device according to an embodiment.
FIG. 7A illustrates an exemplary electronic device according to an embodiment.
FIG. 7B is a cross-sectional view illustrating an example of an exemplary electronic device cut along line B-B' of FIG. 7A according to an embodiment.
FIG. 8A illustrates an example of an unfolded state of an electronic device according to an embodiment.
FIG. 8B illustrates an example of a fully folded state of an electronic device according to an embodiment.

### [Mode for Invention]

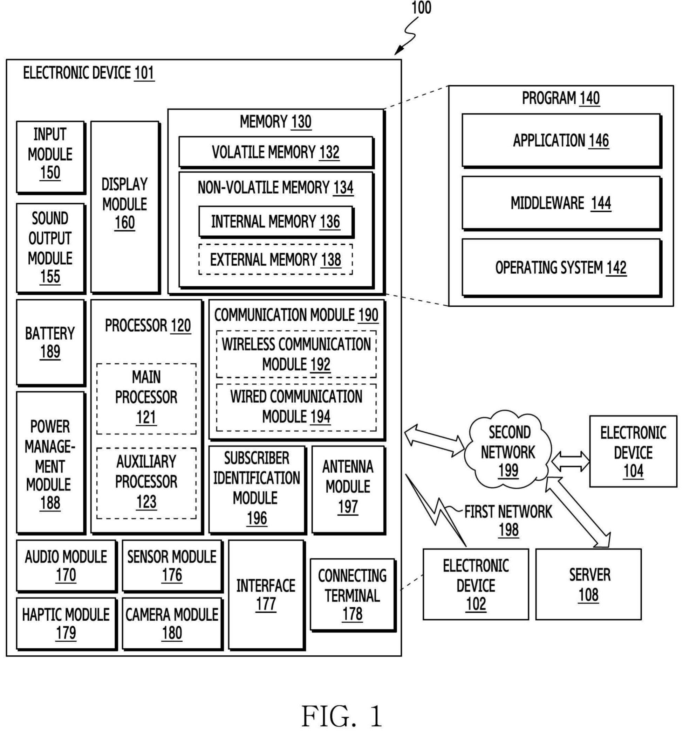

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

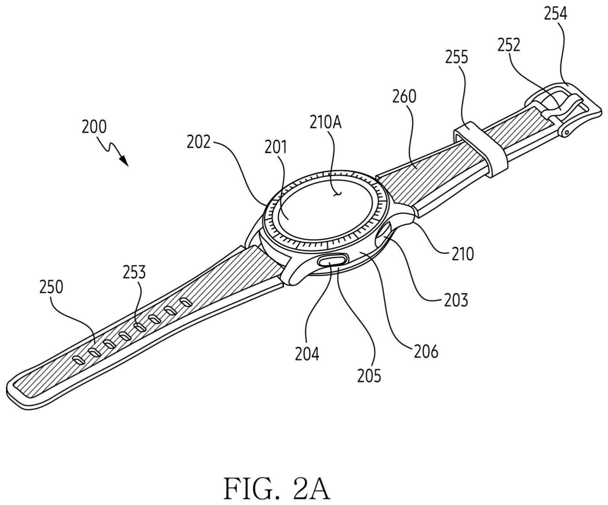

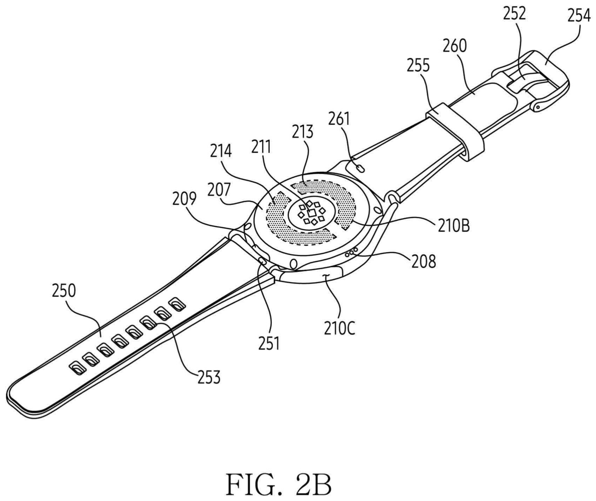

FIGS. 2A and 2B are perspective views of an exemplary electronic device according to an embodiment.

Referring to FIGS. 2A and 2B, according to an embodiment, an electronic device 200 (e.g., the electronic device 101 of FIG. 1) may include a housing 210 that includes a first surface (or a front surface) 210A, a second surface (or a rear surface) 210B, and a lateral surface 210C surrounding a space between at least a portion of the first surface 210A and the second surface 210B, and fastening members 250 and 260 configured to be connected to at least a portion of the housing 210 and be detachably fasten the electronic device 200 to a portion of a body of a user (e.g., a wrist, an ankle, a head, a neck, an arm, a waist, and/or a leg). In an embodiment (not illustrated), the housing may refer to a structure forming a portion of the first surface 210A, the second surface 210B, and the lateral surfaces 210C. According to an embodiment, at least a portion of the first surface 210A may be formed of a substantially transparent front plate 201 (e.g., a glass plate including various coating layers or a polymer plate). The second surface 210B may be implemented by a substantially opaque rear plate 207. For example, the rear plate 207 may be implemented by coated or colored glass, ceramic, polymer, metal (e.g., aluminum, stainless steel (STS), or magnesium), or a combination of at least two of the materials. The lateral surface 210C may be formed by a lateral bezel structure (or "a lateral member") 206 including metal and/or polymer by being coupled to the front plate 201 and the rear plate 207. In some embodiments, the rear plate 207 and the lateral bezel structure 206 may be integrally formed, and may include the same material (e.g., a metal material such as aluminum). The fastening members 250 and 260 may be formed of various materials and shapes. The fastening members 250 and 260 may be formed by of a woven fabric, leather, rubber, urethane, metal, ceramic, or a combination of at least two of the materials.

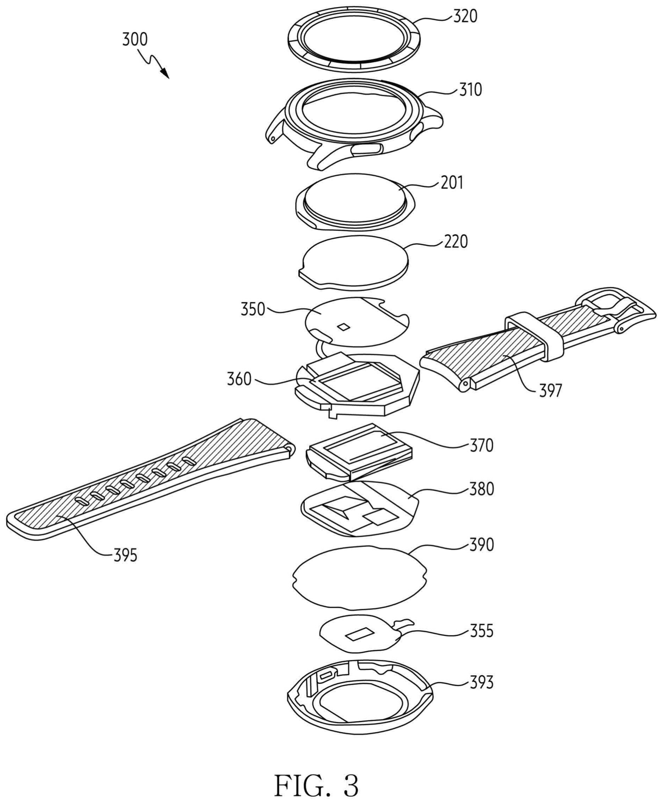

According to an embodiment, the electronic device 200 may include at least one or more of a display 220 (refer to FIG. 3), audio modules 205 and 208, a sensor module 211, key input devices 202, 203 and 204, and a connector hole 209. In some embodiments, the electronic device 200 may omit at least one (e.g., the key input devices 202, 203 and 204, the connector hole 209, or the sensor module 211) of components, or may additionally include another component.

For example, the display 220 may be exposed through a large portion of the front plate 201. A shape of the display 220 may be a shape corresponding to a shape of the front plate 201, and may be various shapes such as a circle, an oval, or a polygon, and the like. The display 220 may be coupled to or disposed adjacent to a touch sensing circuit, a pressure sensor capable of measuring intensity (pressure) of a touch, and/or a fingerprint sensor.

The audio modules 205 and 208 may include a microphone hole 205 and a speaker hole 208. The microphone for obtaining an external sound may be disposed inside the microphone hole 205, and in some embodiments, a plurality of microphones may be disposed to detect a direction of sound. The speaker hole 208 may be used as an external speaker and a receiver for a call. In some embodiments, the speaker hole 208 and the microphone hole 205 may be implemented as one hole, or a speaker without the speaker hole 208 (e.g., a piezo speaker) may be included.

The sensor module 211 may generate an electrical signal or a data value corresponding to an internal operating state of the electronic device 200 or an external environmental state. For example, the sensor module 211 may include a biometric sensor module 211 (e.g., an HRM sensor) disposed on the second surface 210B of the housing 210. The electronic device 200 may further include at least one of a sensor module not illustrated, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The sensor module 211 may include electrode regions 213 and 214 forming a portion of a surface of the electronic device 200 and a bio signal detection circuit (not illustrated) electrically connected to the electrode regions 213 and 214. For example, the electrode regions 213 and 214 may include a first electrode region 213 and a second electrode region 214 disposed on the second surface 210B of the housing 210. The sensor module 211 may be configured such that the electrode regions 213 and 214 obtain an electrical signal from a portion of the body of the user, and the bio signal detection circuit detects biometric information of the user based on the electrical signal.

The key input devices 202, 203, and 204 may include a wheel key 202 disposed on the first surface 210A of the housing 210 and rotatable in at least one direction, and/or a side key button 203 or 204 disposed on the lateral surface 210C of the housing 210. The wheel key may be a shape corresponding to a shape of the front plate 201. In an embodiment, the electronic device 200 may not include a portion or all of the key input devices 202, 203, and 204 mentioned above, and the key input devices 202, 203, and 204 that are not included may be implemented in another form such as a soft key on the display 220. The connector hole 209 may include another connector hole (not illustrated) capable of accommodating a connector (e.g., a USB connector) for transmitting and receiving power and/or data with an external electronic device and capable of accommodating a connector for transmitting and receiving an audio signal with the external electronic device. For example, the electronic device 200 may further include a connector cover (not illustrated) covering at least a portion of the connector hole 209 and blocking (or reducing) inflow of an external foreign substance into the connector hole.

The fastening members 250 and 260 may be detachably fastened to at least a partial region of the housing 210 by using locking members 251 and 261. The fastening members 250 and 260 may include one or more of a fixing member 252, a fixing member fastening hole 253, a band guide member 254, and a band fixing ring 255.

The fixing member 252 may be configured to fix the housing 210 and the fastening members 250 and 260 to a portion of the body of the user (e.g., the wrist, the ankle, the head, the neck, the arm, the waist, and/or the leg). The fixing member fastening hole 253 may fix the housing 210 and the fastening members 250 and 260 to the portion of the body of the user by corresponding to the fixing member 252. The band guide member 254 may allow the fastening members 250 and 260 to be fastened in close contact with the portion of the body of the user by being configured to limit a range of movement of the fixing member 252 when the fixing member 252 is fastened with the fixing member fastening hole 253. The band fixing ring 255 may limit a range of movement of the fastening members 250 and 260 in a state in which the fixing member 252 and the fixing member fastening hole 253 are fastened.

FIG. 3 is an exploded perspective view of an exemplary electronic device according to an embodiment.

Referring to FIG. 3, an electronic device 300 (e.g., the electronic device 101 of FIG. 1, and the electronic device 200 of FIGS. 2A and/or 2B) may include a lateral bezel structure 310, a wheel key 320, a front plate 201, a display 220, a first antenna 350, a second antenna 355, a support member 360 (e.g., a bracket), a battery 370, a printed circuit board 380, a sealing member 390, a rear plate 393, and fastening members 395 and 397. At least one of components of the electronic device 300 may be the same as or similar to at least one of components of the electronic device 200 of FIGS. 1, 2A and/or 2B, and an overlapping description will be omitted below. The support member 360 may be connected to the lateral bezel structure 310 by being disposed inside the electronic device 300, or may be integrally formed with the lateral bezel structure 310. For example, the support member 360 may be formed of a metal material and/or a non-metal material (e.g., polymer). The display 220 may be coupled to a surface of the support member 360, and the printed circuit board 380 may be coupled to another surface of the support member 360. The printed circuit board 380 may be equipped with a processor, memory, and/or an interface. For example, the processor may include one or more of a central processing unit, an application processor, a graphic processing unit, an application processor sensor processor, a communication processor.

For example, the memory may include a volatile memory or a non-volatile memory. For example, the interface may include a high definition multimedia interface (HDMI), a universal serial bus (USB) interface, an SD card interface, and/or an audio interface. For example, the interface may electrically or physically connect the electronic device 300 to an external electronic device, and may include a USB connector, an SD card/MMC connector, or an audio connector.

The battery 370 is a device for supplying power to at least one component of the electronic device 300 and may include, for example, a non-rechargeable primary battery, a rechargeable secondary battery, or a fuel cell. For example, at least a portion of the battery 370 may be disposed on substantially the same plane as the printed circuit board 380. The battery 370 may be integrally disposed inside the electronic device 200 or may be detachably disposed from the electronic device 200.

The first antenna 350 may be disposed between the display 220 and the support member 360. For example, the first antenna 350 may include a near field communication (NFC) antenna, a wireless charging antenna, and/or a magnetic secure transmission (MST) antenna. For example, the first antenna 350 may perform short-range communication with an external device, or wirelessly transmit and receive power required for charging, and may transmit a short-range communication signal or an electromagnetic signal including payment data. In an embodiment, an antenna structure may be formed by at least a portion of the lateral bezel structure 310 and/or a portion of the support member 360, or a combination thereof. The second antenna 355 may be disposed between the printed circuit board 380 and the rear plate 393. For example, the second antenna 355 may include a near field communication (NFC) antenna, a wireless charging antenna, and/or a magnetic secure transmission (MST) antenna. For example, the second antenna 355 may perform short-range communication with an external device, or wirelessly transmit and receive power required for charging, and may transmit a short-range communication signal or an electromagnetic signal including payment data. In an embodiment, an antenna structure may be formed by the lateral bezel structure 310 and/or a portion of the rear plate 393, or a combination thereof.

The sealing member 390 may be positioned between the lateral bezel structure 310 and the rear plate 393. The sealing member 390 may be configured to block (or reduce) moisture and a foreign substance introduced into a space surrounded by the lateral bezel structure 310 and the rear plate 393 from the outside.

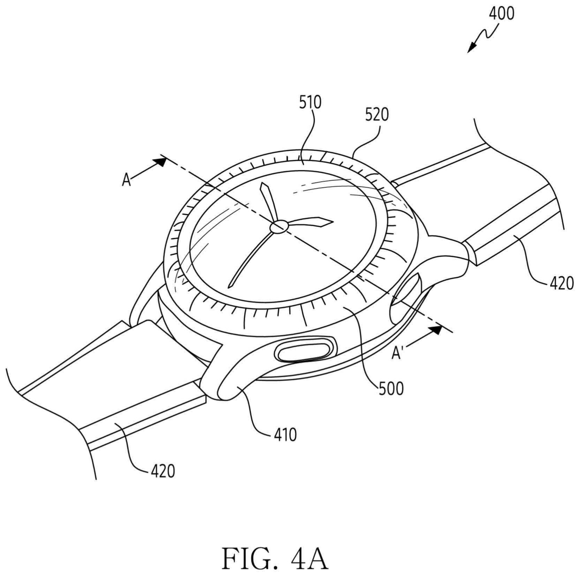

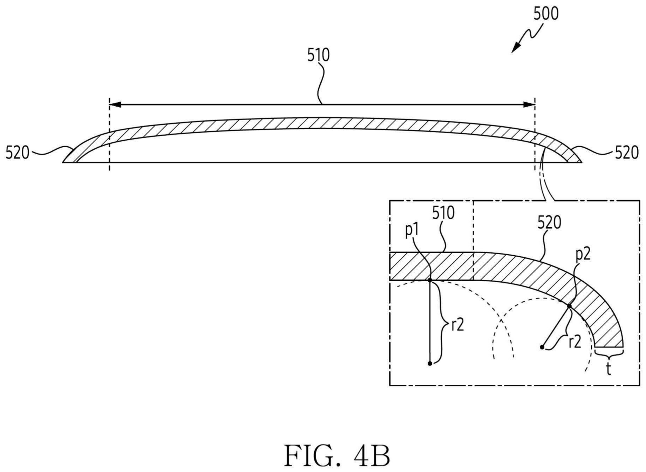

FIG. 4A is a perspective view indicating an example in which a display is disposed on an exemplary electronic device according to an embodiment, and FIG. 4B is a cross-sectional view illustrating an example of an exemplary display cut along line A-A' of FIG. 4A according to an embodiment.

Referring to FIGS. 4A and 4B, according to an embodiment, an electronic device 400 (e.g., the electronic device 101 of FIG. 1, the electronic device 200 of FIGS. 2A, and 2B, and/or the electronic device 300 of FIG. 3) may include a frame 410 (e.g., the housing 210 of FIG. 2A), a plurality of straps 420 (e.g., the fastening members 250 and 260 of FIGS. 2A and 2B), and/or a display 500.

According to an embodiment, the frame 410 may form (or define) an overall exterior of the electronic device 400. The frame 410 may support various components of the electronic device 400. For example, the display 500 may be disposed (or coupled) on the frame 410. The frame 410 may form (or provide) an internal space in which the components of the electronic device 400 may be accommodated (or disposed).

According to an embodiment, the plurality of straps 420 may contact a portion of a body of a user while the electronic device 400 is worn on the user. The plurality of straps 420 may maintain (or fix) a position of the electronic device 400 with respect to a portion of the body of the user while the electronic device 400 is worn on the user. The plurality of straps 420 may be coupled to the frame 410. For example, the plurality of straps 420 may be coupled to the frame 410 to be movable with respect to the frame 410. For example, the plurality of straps 420 may be coupled to the frame 410 to be rotatable (or pivotable) with respect to the frame 410.

According to an embodiment, the display 500 may be configured to provide visual content. The display 500 may be exposed to the outside of the electronic device 400 in a state of being disposed on the frame 410. The display 500 may form (or define) a portion of an exterior of the electronic device 400. At least a portion of the display 500 may have a curved shape to have a curvature. For example, the at least a portion of the display 500 may have a dome shape so as to provide an aesthetic experience to the user through the exterior having various shapes. According to an embodiment, the display 500 may include a first display part 510 and a second display part 520.

According to an embodiment, the first display part 510 may indicate a portion of the display 500. For example, the first display part 510 may indicate a portion of the display 500 configured to display visual content. For example, the first display part 510 may include a plurality of pixels configured to emit light. The first display part 510 may be referred to as a main driving unit (or driving region) of the display 500 for providing the visual content. For example, the first display part 510 may include a central portion of the display 500. According to an embodiment, the first display part 510 may be curved to have a curvature. For example, the first display part 510 may be curved to have different curvatures for each of positions of the first display part 510. In other words, a curvature of the first display part 510 may be changed according to a position of the first display part 510. For example, the curvature of the first display part 510 may have a minimum value at a position adjacent to the central portion of the display 500 and a maximum value at a position adjacent to the second display part 520, but is not limited thereto.

According to an embodiment, the second display part 520 may indicate another portion of the display 500. For example, the second display part 520 may indicate another portion of the display 500 configured to display visual content. For example, the second display part 520 may include a plurality of pixels configured to emit light. The second display part 520 may be referred to as a sub-driving unit (or driving region) of the display 500 for providing the visual content. For example, the second display part 520 may include a periphery of the display 500 surrounding the central portion of the display 500. The second display part 520 may be connected to the first display part 510. For example, the second display part 520 may surround the first display part 510. For example, the second display part 520 may be disposed (or extended) along a periphery of the first display part 510.

According to an embodiment, the second display part 520 may be curved to have a curvature. For example, the second display part 520 may be curved to have different curvatures for each of positions of the second display part 520. In other words, a curvature of the second display part 520 may be changed according to a position of the second display part 520. For example, the curvature of the second display part 520 may have a minimum value at a position adjacent to the first display part 510 and a maximum value at a position adjacent to the frame 410 (or the plurality of straps 420), but is not limited thereto. According to an embodiment, the curvature of the second display part 520 may be greater than the curvature of the first display part 510. For example, a curvature of each of the positions in the second display part 520 may be greater than each curvature in the first display part 510. Since the curvature of the second display part 520 is greater than the curvature of the first display part 510, a strain of the second display part 520 may be greater than a strain of the first display part 510. A strain of a component may indicate a degree of deformation of the component due to stress generated as the component is curved. For example, the strain of the component may be indicated as a ratio of a radius of a curvature at a position of the component to a thickness of the component. The strain of the first display part 510 may be indicated by a first radius of curvature r1 at a first position p1 of the first display part 510 and a thickness t of the first display part 510. The strain of the second display part 520 may be indicated by a second radius of curvature r2 at a second position p2 of the second display part 520 and a thickness t of the second display part 520. Since the curvature of the second display part 520 is greater than the curvature of the first display part 510, the strain of the second display part 520 may be greater than the strain of the first display part 510. For example, as the electronic device 400 having various shapes is manufactured, the first display part 510 and/or the second display part 520 may be curved so that the display 500 has a curvature. Since possibility of damage due to stress is higher as a strain increases, a structure for reducing damage to the second display part 520 may be required. Hereinafter, a structure of the display 500 for reducing damage to the second display part 520 will be described.

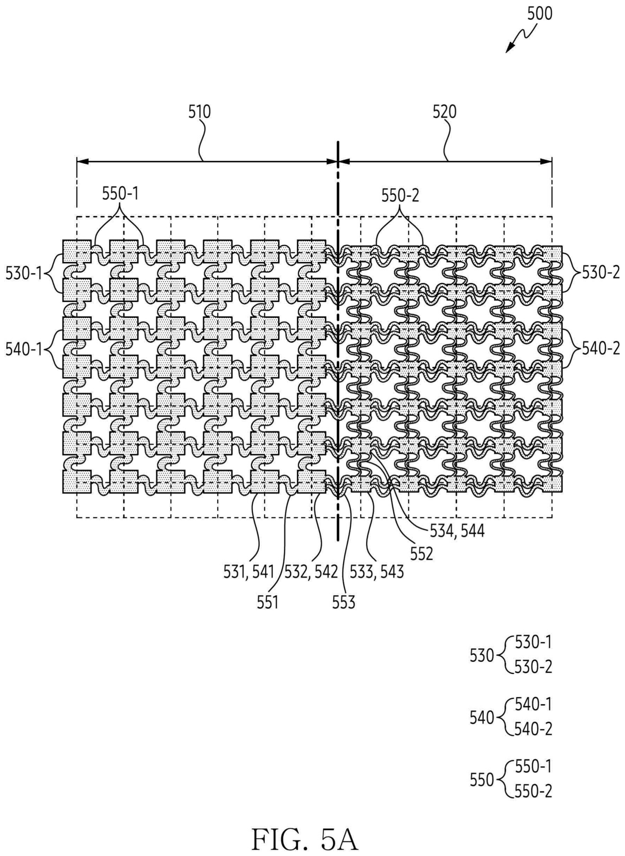

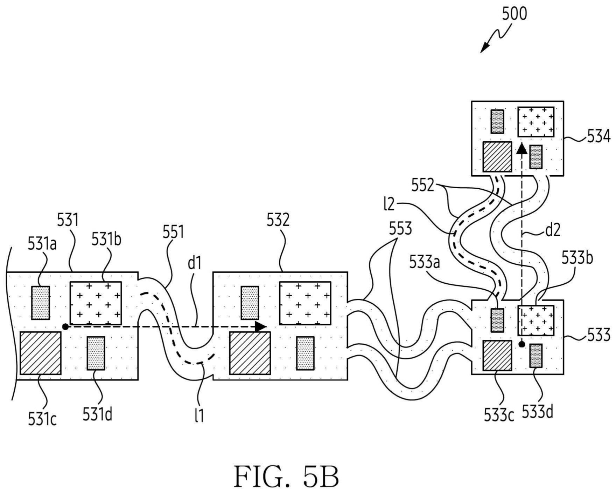

FIG. 5A is a top view enlarging a portion of an exemplary display according to an embodiment, and FIG. 5B is an enlarged view enlarging an exemplary first pixel and third pixel according to an embodiment.

Referring to FIGS. 5A and 5B, according to an embodiment, a display 500 may further include a plurality of pixels 530, a plurality of pixel parts 540, and/or a plurality of connecting parts 550.

According to an embodiment, the plurality of pixels 530 may be configured to emit light so that the display 500 may provide visual content. The plurality of pixels 530 may be disposed in a first display part 510 and a second display part 520. The plurality of pixels 530 may be included in the first display part 510 and the second display part 520. The plurality of pixels 530 may be spaced apart from each other. According to an embodiment, the plurality of pixels 530 may include a first set of pixels 530-1 and a second set of pixels 530-2.

According to an embodiment, the first set of pixels 530-1 may be disposed in the first display part 510. For example, the first set of pixels 530-1 may be spaced apart from each other in the first display part 510. The first set of pixels 530-1 may have substantially the same size as each other. According to an embodiment, the first set of pixels 530-1 may include a first pixel 531, and a second pixel 532. Each of the first pixel 531 and the second pixel 532 may have a first size (or a first area). For example, a size of each of the first pixel 531 and the second pixel 532 may indicate a size when the display 500 is viewed from above. According to an embodiment, each of the first set of pixels 530-1 may include a plurality of first sub-pixels 531a, 531b, 531c, and 531d. For example, each of the first pixel 531 and the second pixel 532 may include the plurality of first sub-pixels 531a, 531b, 531c, and 531d. Each of the first pixel 531 and the second pixel 532 may be formed of the plurality of first sub-pixels 531a, 531b, 531c, and 531d. The plurality of first sub-pixels 531a, 531b, 531c, and 531d may include one sub-pixel for emitting red light, two sub-pixels for emitting green light, and/or one sub-pixel for emitting blue light, but are not limited thereto. For example, the plurality of first sub-pixels 531a, 531b, 531c, and 531d may also include one sub-pixel for emitting red light, one sub-pixel for emitting green light, and/or one sub-pixel for emitting blue light. For example, the plurality of first sub-pixels 531a, 531b, 531c, and 531d may also include one sub-pixel for emitting red light, one sub-pixel for emitting green light, one sub-pixel for emitting blue light, and/or one sub-pixel for emitting white light. For example, sizes of each of the plurality of first sub-pixels 531a, 531b, 531c, and 531d may be different from each other, but are not limited thereto. For example, the sizes of each of the plurality of first sub-pixels 531a, 531b, 531c, and 531d may be the same as each other.

According to an embodiment, the second set of pixels 530-2 may be disposed in the second display part 520. For example, the second set of pixels 530-2 may be spaced apart from each other in the second display part 520. The second set of pixels 530-2 may have substantially the same size as each other. According to an embodiment, the second set of pixels 530-2 may include a third pixel 533, and a fourth pixel 534. Each of the third pixel 533, and the fourth pixel 534 may have a second size (or a second area) smaller than the first size. For example, the second size may be approximately 0.6 times the first size, but is not limited thereto. For example, a size of each of the third pixel 533, and the fourth pixel 534 may indicate a size when the display 500 is viewed from above. According to an embodiment, each of the second set of pixels 530-2 may include a plurality of second sub-pixels 533a, 533b, 533c, and 533d. For example, each of the third pixel 533, and the fourth pixel 534 may include the plurality of second sub-pixels 533a, 533b, 533c, and 533d. Each of the third pixel 533, and the fourth pixel 534 may be formed of the plurality of second sub-pixels 533a, 533b, 533c, and 533d. The plurality of second sub-pixels 533a, 533b, 533c, and 533d may include one sub-pixel for emitting red light, two sub-pixels for emitting green light, and/or one sub-pixel for emitting blue light, but are not limited thereto. For example, the plurality of second sub-pixels 533a, 533b, 533c, and 533d may also include one sub-pixel for emitting red light, one sub-pixel for emitting green light, and/or one sub-pixel for emitting blue light. For example, the plurality of second sub-pixels 533a, 533b, 533c, and 533d may also include one sub-pixel for emitting red light, one sub-pixel for emitting green light, one sub-pixel for emitting blue light, and/or one sub-pixel for emitting white light. For example, sizes of each of the plurality of second sub-pixels 533a, 533b, 533c, and 533d may be different from each other, but are not limited thereto. For example, sizes of each of the plurality of second sub-pixels 533a, 533b, 533c, and 533d may be the same as each other. According to an embodiment, sizes of the plurality of second sub-pixels 533a, 533b, 533c, and 533d may be smaller than sizes of the plurality of first sub-pixels 531a, 531b, 531c, and 531d. For example, a size of each of the plurality of second sub-pixels 533a, 533b, 533c, and 533d may be smaller than a size of each of the plurality of first sub-pixels 531a, 531b, 531c, and 531d, but is not limited thereto.

According to an embodiment, distances between centers of each of the plurality of pixels 530 may be the same. For example, a first distance d1 between the first pixel 531 and the second pixel 532 may be substantially the same as a second distance d2 between the third pixel 534 and the fourth pixel 534. The first distance d1 may indicate a linear distance between a center of the first pixel 531 and a center of the second pixel 532. The second distance d2 may indicate a linear distance between a center of the third pixel 533 and a center of the fourth pixel 534. As the distances between the centers of each of the plurality of pixels 530 is the same as each other, PPI of the display 500 may be maintained substantially the same in the first display part 510 and the second display part 520.

According to an embodiment, each of the plurality of pixel parts 540 may support the plurality of pixels 530. For example, each of the plurality of pixel parts 540 may indicate a portion (or a region) of the display 500 in which the plurality of pixels 530 are disposed. For example, each of the plurality of pixel parts 540 may include other components (e.g., a thin film transistor (TFT)) in the display 500 for driving the plurality of pixels 530. For example, one pixel among the plurality of pixels 530 may be disposed in each of the plurality of pixel parts 540, but is not limited thereto. For example, two or more pixels among the plurality of pixels 530 may also be disposed in each of the plurality of pixel parts 540. According to an embodiment, each of the plurality of pixel parts 540 may include a first set of pixel parts 540-1 and a second set of pixel parts 540-2.

According to an embodiment, the first set of pixel parts 540-1 may be disposed in the first display part 510. For example, the first set of pixel parts 540-1 may be spaced apart from each other in the first display part 510. The first set of pixel parts 540-1 may have substantially the same size as each other. According to an embodiment, the first set of pixel parts 540-1 may include a first pixel part 541 and a second pixel part 542. The first pixel part 541 may include the first pixel 531. The first pixel 531 may be disposed in the first pixel part 541. The second pixel part 542 may include the second pixel 532. The second pixel 532 may be disposed in the second pixel part 542.

According to an embodiment, the second set of pixel parts 540-2 may be disposed in the second display part 520. For example, the second set of pixel parts 540-2 may be spaced apart from each other in the second display part 520. The second set of pixel parts 540-2 may have substantially the same size as each other. According to an embodiment, the second set of pixel parts 540-2 may include a third pixel part 543 and a fourth pixel part 544. The third pixel part 543 may include the third pixel 533. The third pixel 533 may be disposed in the third pixel part 543. The fourth pixel part 544 may include the fourth pixel 534. The fourth pixel 534 may be disposed in the fourth pixel part 544. According to an embodiment, a size of each of the second set of pixel parts 540-2 may be smaller than a size of each of the first set of pixel parts 540-1. For example, a size of each of the first pixel part 541 and the second pixel part 542 may be greater than a size of each of the third pixel part 543 and the fourth pixel part 544.

According to an embodiment, the plurality of connecting parts 550 may electrically connect the plurality of pixels 530. For example, each of the plurality of connecting parts 550 may include a connecting line electrically connecting the plurality of pixels 530. For example, the connecting line may be formed of a conductive material. For example, the plurality of connecting parts 550 may be connected to the plurality of pixels 530. For example, the plurality of connecting parts 550 may connect the plurality of pixel parts 540 in which each of the plurality of pixels 530 is disposed. The plurality of connecting parts 550 may be disposed between the plurality of pixels 530. For example, the plurality of connecting parts 550 may be disposed between the plurality of pixel parts 540 in which the plurality of pixels 530 are disposed. According to an embodiment, the plurality of connecting parts 550 may include a first set of connecting parts 550-1 and a second set of connecting parts 550-2.

According to an embodiment, the first set of connecting parts 550-1 may be disposed in the first display part 510. The first set of connecting parts 550-1 may connect the first set of pixels 530-1. Each of the first set of connecting parts 550-1 may be disposed between each of the first set of pixels 530-1. The first set of connecting parts 550-1 may connect the first set of pixel parts 540-1. Each of the first set of connecting parts 550-1 may be disposed between each of the first set of pixel parts 540-1. According to an embodiment, the first set of connecting parts 550-1 may have a curved shape. As the first set of connecting parts 550-1 has a curved shape, the display 500 may be robust to stress generated as the display 500 is curved. For example, the first set of connecting parts 550-1 may be curved to have a curvature. For example, each of the first set of connecting parts 550-1 may have a serpentine shape. According to an embodiment, the first set of connecting parts 550-1 may include at least one first connecting part 551 connecting the first pixel 531 and the second pixel 532. The at least one first connecting part 551 may connect the first pixel 531 and the second pixel 532. For example, the at least one first connecting part 551 may extend from the first pixel 531 to the second pixel 532. For example, the at least one first connecting part 551 may connect the first pixel part 541 and the second pixel part 542.

According to an embodiment, at least a portion of the second set of connecting parts 550-2 may be disposed in the second display part 520. For example, at least a portion of the second set of connecting parts 550-2 may connect the second set of pixels 530-2. Each of the second set of connecting parts 550-2 may be disposed between each of the second set of pixels 530-2. The second set of connecting parts 550-2 may connect the second set of pixel parts 540-2. Each of the second set of connecting parts 550-2 may be disposed between each of the second set of pixel parts 540-2. For example, a portion of the second set of connecting parts 550-2 may connect the first set of pixels 530-1 and the second set of pixels 530-2. For example, a portion of the second set of connecting parts 550-2 may be disposed between the first display part 510 and the second display part 520. For example, a portion of the second set of connecting parts 550-2 may connect one pixel among the first set of pixels 530-1 disposed in the first display part 510 and one pixel among the second set of pixels 530-2 disposed in the second display part 520. According to an embodiment, the second set of connecting parts 550-2 may have a curved shape. As the second set of connecting parts 550-2 has a curved shape, the display 500 may be robust to stress generated as the display 500 is curved. For example, the second set of connecting parts 550-2 may be curved to have a curvature. For example, each of the second set of connecting parts 550-2 may have a serpentine shape. According to an embodiment, the second set of connecting parts 550-2 may include a plurality of second connecting parts 552 connecting the third pixel 533 and the fourth pixel 534. The plurality of second connecting parts 552 may connect the third pixel 533 and the fourth pixel 534. For example, the plurality of second connecting parts 552 may extend from the third pixel 533 to the fourth pixel 534. For example, the plurality of second connecting parts 552 may connect the third pixel part 543 and the fourth pixel part 544.

According to an embodiment, a resistance value of the second set of connecting parts 550-2 may be substantially the same as a resistance value of the first set of connecting parts 550-1. For example, a resistance value of the at least one first connecting part 551 may be substantially the same as a sum of a resistance value of each of the plurality of second connecting parts 552. Since the resistance value of the at least one first connecting part 551 is substantially the same as the sum of the resistance value of each of the plurality of second connecting parts 552, the plurality of pixels 530 disposed in the first display part 510 and the second display part 520 may be easily controlled.

According to an embodiment, a length of each of the second set of connecting parts 550-2 may be longer than a length of each of the first set of connecting parts 550-1. For example, a length of the at least one first connecting part 551 may be shorter than a length of each of the plurality of second connecting parts 552. A length of a component may indicate a distance in a direction parallel to an extension direction when the component has an extended shape. For example, the length of the at least one first connecting part 551 may indicate a length in which the at least one first connecting part 551 is curved and extends between the first pixel 531 and the second pixel 532. In other words, the length of the at least one first connecting part 551 may not indicate a linear distance between the first pixel 531 and the second pixel 532. For example, the length of each of the plurality of second connecting parts 552 may indicate a length in which each of the plurality of second connecting parts 552 is curved and extends between the third pixel 533 and the fourth pixel 534. In other words, the length of each of the plurality of second connecting parts 552 may not indicate a linear distance between the third pixel 533 and the fourth pixel 534. For example, the at least one first connecting part 551 may have a first length l1, and each of plurality of second connecting parts 552 may have a second length l2 longer than the first length l1. For example, the second length l2 may be 1.5 times the first length l1, but is not limited thereto. Since a curvature of the second display part 520 is greater than a curvature of the first display part 510, a magnitude of stress applied to each of the plurality of second connecting parts 552 disposed in the second display part 520 may be greater than a magnitude of stress applied to the at least one first connecting part 551 disposed in the first display part 510. Since damage due to stress is reduced as a length increases, the display 500 according to an embodiment may provide a structure in which damage to the plurality of second connecting parts 552 may be reduced.

According to an embodiment, the number of the second set of connecting parts 550-2 may be greater than the number of the first set of connecting parts 550-1. For example, the number of the at least one first connecting part 551 between the first pixel 531 and the second pixel 532 may be smaller than the number of the plurality of second connecting parts 552 between the third pixel 533 and the fourth pixel 534. For example, in FIGS. 5A and 5B, the number of the at least one first connecting part 551 is illustrated as one, but the number of the at least one first connecting part 551 may also be two or more.

According to an embodiment, according to an embodiment, a size of a cross-sectional area of each of the second set of connecting parts 550-2 may be smaller than a size of a cross-sectional area of each of the first set of connecting parts 550-1. A cross-sectional area of a component may indicate a cross-sectional area when the component is cut in a direction perpendicular to an extension direction of the component. For example, a cross-sectional area of the at least one first connecting part 551 between the first pixel 531 and the second pixel 532 may be greater than a cross-sectional area of each of the plurality of second connecting parts 552 between the third pixel 533 and the fourth pixel 534. For example, the cross-sectional area of each of the plurality of second connecting parts 552 between the third pixel 533 and the fourth pixel 534 may be approximately 0.75 times the cross-sectional area of the at least one first connecting part 551 between the first pixel 531 and the second pixel 532. A sum of the cross-sectional area of each of the second set of connecting parts 550-2 may be larger than a sum of the cross-sectional area of each of the first set of connecting parts 550-1. For example, a sum of the cross-sectional area of each of the plurality of second connecting parts 552 between the third pixel 533 and the fourth pixel 534 may be approximately 1.5 times the cross-sectional area of the at least one first connecting part 551 between the first pixel 531 and the second pixel 532. However, it is not limited thereto. A resistance value of a component may be proportional to a length of the component and inversely proportional to a cross-sectional area of the component. Since the second length l2 of each of the plurality of second connecting parts 552 is longer than the first length l1 of the at least one first connecting part 551 to reduce damage due to stress, the sum of the cross-sectional area of each of the plurality of second connecting parts 552 may be larger than a sum of the at least one first connecting part 551. As the sum of the cross-sectional areas of each of the plurality of second connecting parts 552 is larger than the sum of the at least one first connecting part 551, the resistance value of the at least one first connecting part 551 and the resistance value of the plurality of second connecting parts 552 may be substantially the same.

According to an embodiment, the plurality of connecting parts 550 may include a plurality of third connecting parts 553. The plurality of third connecting parts 553 may connect the second pixel 532 disposed in the first display part 510 and the third pixel 533 disposed in the second display part 520. For example, the plurality of third connecting parts 553 may connect the second pixel part 542 and the third pixel part 543. A size of the plurality of third connecting parts 553 may be substantially the same as the plurality of second connecting parts 552. For example, a length of each of the plurality of third connecting parts 553 may be the second length l2 which is a length of each of the plurality of second connecting parts 552. For example, a cross-sectional area of each of the plurality of third connecting parts 553 may be substantially the same as the cross-sectional area of each of the plurality of second connecting parts 552.

On the other hand, in FIG. 5B, it is illustrated that the first distance d1 and the second distance d2 are substantially the same so that the PPI of the display 500 is substantially constant, but is not limited thereto. For example, the first distance d1 and the second distance d2 may be different from each other. In a case that the first distance d1 and the second distance d2 are different, PPI in the first display part 510 may be different from PPI in the second display part 520.

As described above, according to an embodiment, the display 500 may provide a structure capable of smoothly displaying visual content to a user while reducing damage to the second display part 520 since the cross-sectional area of the plurality of second connecting parts 552 disposed in the second display part 520 having a relatively large curvature is larger than the cross-sectional area of the at least one first connecting part 551, and the second length l2 of each of the plurality of second connecting parts 552 is longer than the first length l1 of the at least one first connecting part 551. Meanwhile, in FIGS. 4A and 4B, the display 500 according to an embodiment is illustrated as being disposed on the electronic device 400 having a watch shape, but is not limited thereto. For example, according to an embodiment, the display 500 may be disposed on a foldable device and/or a rollable device.

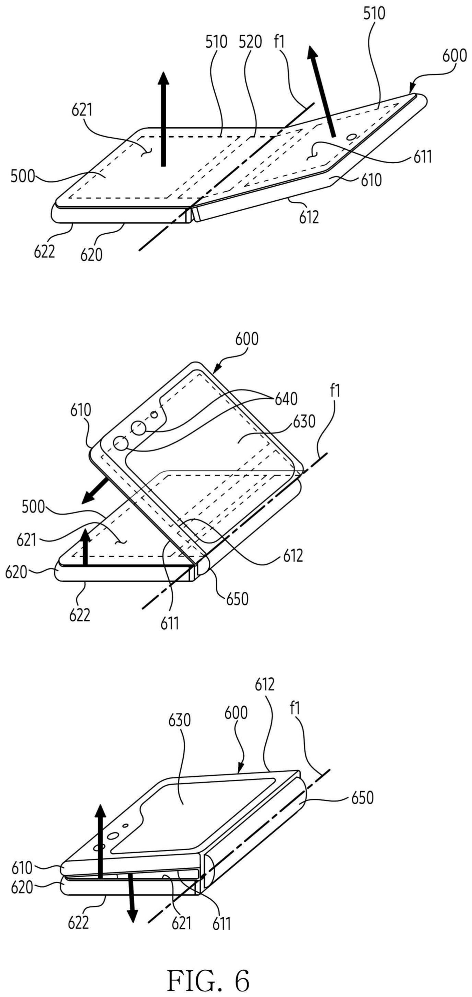

FIG. 6 illustrates an exemplary electronic device according to an embodiment.

Referring to FIG. 6, an electronic device 600 (e.g., the electronic device 101 of FIG. 1) may include a display 500, a first housing 610, a second housing 620, at least one camera 640 (e.g., the camera module 180 of FIG. 1), and/or a hinge structure 650.

According to an embodiment, the first housing 610 and the second housing 620 may form at least a portion of an outer surface of the electronic device 600 that may be gripped by a user. At least a portion of the outer surface of the electronic device 600 defined by the first housing 610 and the second housing 620 may be in contact with a portion of a body of the user when the electronic device 600 is used by the user. According to an embodiment, the first housing 610 may include a first surface 611, and a second surface 612 facing the first surface 611 and spaced apart from the first surface 611. The second surface 612 may be opposite to the first surface 611. For example, a direction in which the second surface 612 faces may be opposite to a first direction d1 in which the first surface 611 faces.

According to an embodiment, the second housing 620 may include a third surface 621, and a fourth surface 622 facing the third surface 621 and spaced apart from the third surface 621. The fourth surface 622 may be opposite to the third surface 621. For example, a direction in which the fourth surface 622 faces may be opposite to a second direction d2 in which the third surface 621 faces. According to an embodiment, the second housing 620 may be coupled to the first housing 610 to be rotatable with respect to the first housing 610.

According to an embodiment, the display 500 may be disposed on the first surface 611 of the first housing 610 and the third surface 621 of the second housing 620 across the hinge structure 650. For example, the display 500 may be referred to as a flexible display. According to an embodiment, the display 500 may further include a sub-display 630 disposed in the second surface 622 of the first housing 610. For example, the sub-display 630 may be exposed to the outside of the electronic device 600 through the second surface 622.

According to an embodiment, a first display part 510 of the display 500 may be disposed on the first housing 610 and/or the second housing 620. A second display part 520 of the display 500 may be disposed on the hinge structure 650. The second display part 520 may be aligned with the hinge structure 650. However, it is not limited thereto. For example, the second display part 520 may also be disposed along a periphery of the first display part 510.

According to an embodiment, at least one camera 640 may be configured to obtain an image based on receiving light from an external subject of the electronic device 600. For example, the at least one camera 640 may be disposed inside the first housing 610, and at least a portion of the camera 640 may be visible through the second surface 612 of the first housing 610.

According to an embodiment, the hinge structure 650 may rotatably connect the first housing 610 and the second housing 620. The hinge structure 650 may be disposed between the first housing 610 and the second housing 620 of the electronic device 101 so that the electronic device 600 may be folded. The hinge structure 650 may change the electronic device 600 into an unfolding state in which the first direction d1 that the first surface 611 of the first housing 610 faces and the second direction d2 that the third surface 621 of the second housing 620 faces is substantially the same as each other, or into a folding state in which the first surface 611 and the third surface 621 face each other. When the electronic device 600 is in the folded state, the first housing 610 and the second housing 620 may be stacked or overlapped by facing each other. According to an embodiment, when the electronic device 600 is in the folded state, the first direction d1 in which the first surface 611 faces and the second direction d2 in which the third surface 621 faces may be different from each other. For example, when the electronic device 600 is in the folded state, the direction d1 in which the first surface 611 faces and the second direction d2 in which the third surface 621 faces may be opposite to each other. However, it is not limited thereto. For example, a state of the electronic device 600 may include an intermediate state in which the first direction d1 in which the first surface 611 faces and the second direction d2 in which the third surface 621 faces are inclined with respect to each other. When the first direction d1 in which the first surface 611 faces is inclined with respect to the second direction d2 in which the third surface 621 faces, the first housing 610 may be inclined with respect to the second housing 620. For example, the intermediate state of the electronic device 600 may be referred to as a flex mode.

In FIG. 6, it is illustrated that the display 500 is not exposed to the outside of the electronic device 600 in the folded state of the electronic device 600, but is not limited thereto. For example, the second housing 620 may be rotatable with respect to the first housing 610 so that the second surface 612 and the fourth surface 622 face each other in the folded state of the electronic device 600. For example, the second housing 620 may be rotatable with respect to the first housing 610 so that the display 500 is directly exposed to the outside of the electronic device 600 in the folded state of the electronic device 600.

According to an embodiment, the electronic device 600 may be foldable based on a folding axis f1. The display 500 may be foldable based on the folding axis f1 by movement of the second housing 620 with respect to the first housing 610.

For example, the folding axis f1 may mean a virtual line extending through the hinge structure 650 in a direction substantially perpendicular to a longitudinal direction of the electronic device 600, but is not limited thereto. For example, the folding axis f1 may mean a virtual line extending in a direction substantially parallel to the longitudinal direction of the electronic device 600, but is not limited thereto. In case that the folding axis f1 extends in the direction substantially parallel to the longitudinal direction of the electronic device 600, the hinge structure 650 may connect the first housing 610 and the second housing 620 by extending in a direction parallel to the folding axis f1.

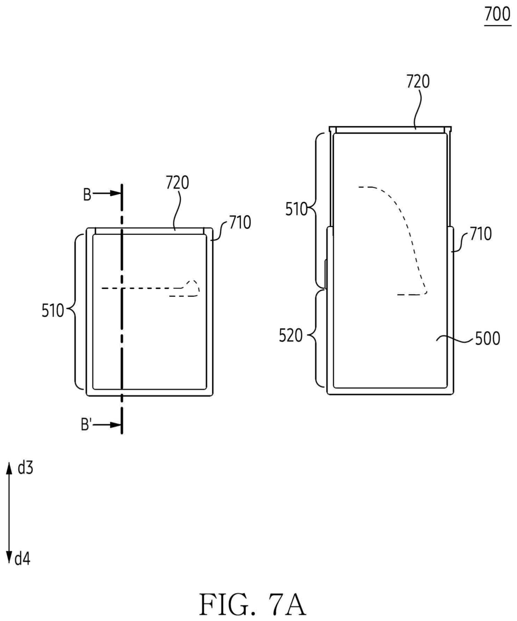

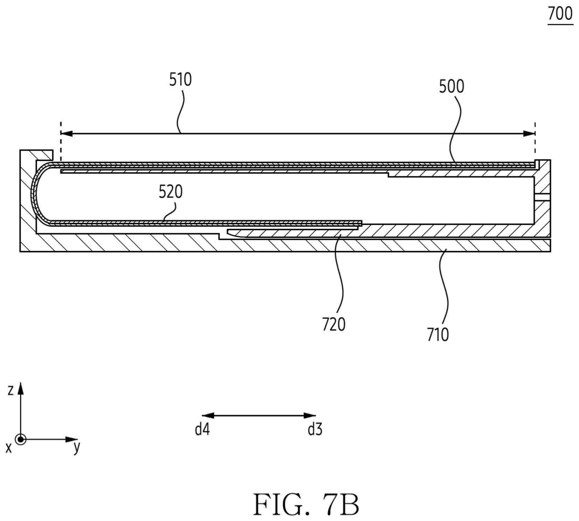

FIG. 7A illustrates an exemplary electronic device according to an embodiment, and FIG. 7B is a cross-sectional view illustrating an example of an exemplary electronic device cut along line B-B' of FIG. 7A according to an embodiment.

Referring to FIGS. 7A and 7B, an electronic device 700 may include a display 500, a first housing 710, and/or a second housing 720.

According to an embodiment, the first housing 710 may accommodate at least a portion of the second housing 720. The first housing 710 may cover (or surround) at least a portion of the second housing 720.

According to an embodiment, the second housing 720 may be movable with respect to the first housing 710. The second housing 720 may be linearly movable with respect to the first housing 710. The second housing 720 may be slidable with respect to the first housing 710. For example, the second housing 720 may be movable with respect to the first housing 710 along a third direction d3 and/or a fourth direction d4 opposite to the third direction d3. As the second housing 720 moves along the third direction d3, the second housing 720 may slide to the outside of the first housing 710. As the second housing 720 moves in the fourth direction d4, the second housing 720 may slide to the inside of the first housing 710. A state of the electronic device 700 may be changed by the movement of the second housing 720 with respect to the first housing 710. The state of the electronic device 700 may include a slide-in state and/or a slide-out state. In the slide-in state of the electronic device 700, the second housing 720 may be movable with respect to the first housing 710 in the third direction d3 of the third direction d3 and the fourth direction d4. For example, in the slide-in state of the electronic device 700, the second housing 720 may be movable only in the third direction d3. In the slide-out state of the electronic device 700, the second housing 720 may be movable with respect to the first housing 710 in the fourth direction d4 of the third direction d3 and the fourth direction d4. For example, in the slide-out state of the electronic device 700, the second housing 720 may be movable only in the fourth direction d4.

According to an embodiment, the display 500 may be disposed on the second housing 720. The display 500 may be movable with respect to the first housing 710 by the movement of the second housing 720 with respect to the first housing 710. For example, the display 500 may move from the inside of the first housing 710 to the inside of the first housing 710 by the movement of the second housing 720 in the third direction d3. For example, in the slide-out state of the electronic device 700, a size of the electronic device 700 exposed to the outside of the first housing 710 may be maximum. For example, the display 500 may move from the outside of the first housing 710 to the inside of the first housing 710 by the movement of the second housing 720 in the fourth direction d4. For example, the display 500 may be rolled into the inside of the first housing 710 from the outside of the first housing 710 by the movement of the second housing 720 in the fourth direction d4.

According to an embodiment, a first display part 510 may be disposed on the second housing 720. A shape of the first display part 510 may be maintained independently of the movement of the second housing 720 with respect to the first housing 710. The first display part 510 may not be deformed by the movement of the second housing 720 with respect to the first housing 710. The first display part 510 may be exposed to the outside of the first housing 710 independently of the movement of the second housing 720 with respect to the first housing 710.

According to an embodiment, a second display part 520 may be connected to the first display part 510. The second display part 520 may be positioned (or accommodated) inside the first housing 710 and the second housing 720 in the slide-in state of the electronic device 700. At least a portion of the second display part 520 may be positioned (or exposed) outside the first housing 710 and the second housing 720 in the slide-out state of the electronic device 700.

According to an embodiment, a size of a display region of the display 500 that may be visible from the outside in the slide-in state of the electronic device 700 may be minimum. For example, only the first display part 510 may be exposed in the slide-in state of the electronic device 700. A position of the second housing 720 with respect to the first housing 710 while the state of the electronic device 700 is in the slide-in state may be referred to as a reduced position. In the slide-out state of the electronic device 700, a size of a display region of the display 500 that may be visible from the outside may be maximum. For example, in the slide-out state of the electronic device 700, at least a portion of the first display part 510, and the second display part 520 may be exposed. However, it is not limited thereto. For example, in the slide-out state of the electronic device 700, the second display part 520 may not be exposed to the outside of the first housing 710. A position of the second housing720 with respect to the first housing 710 while the state of the electronic device 700 is in the slide-out state may be referred to as an expansion position.

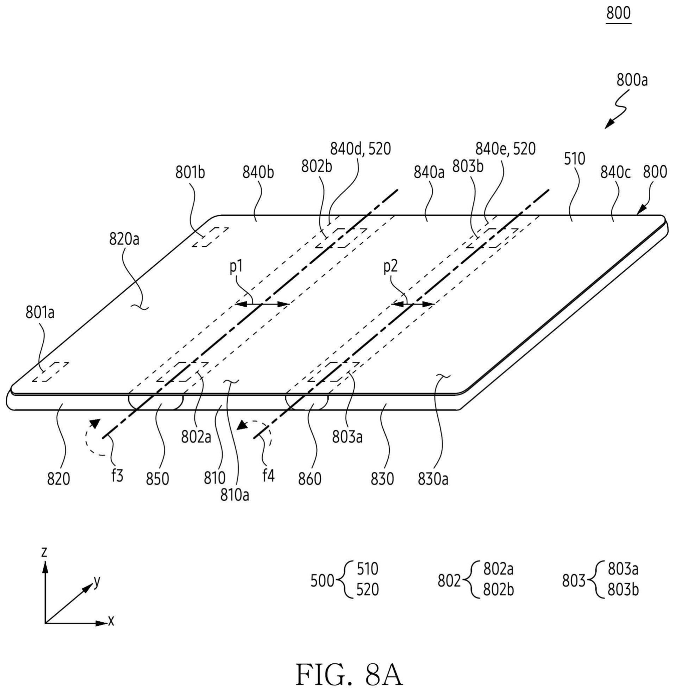

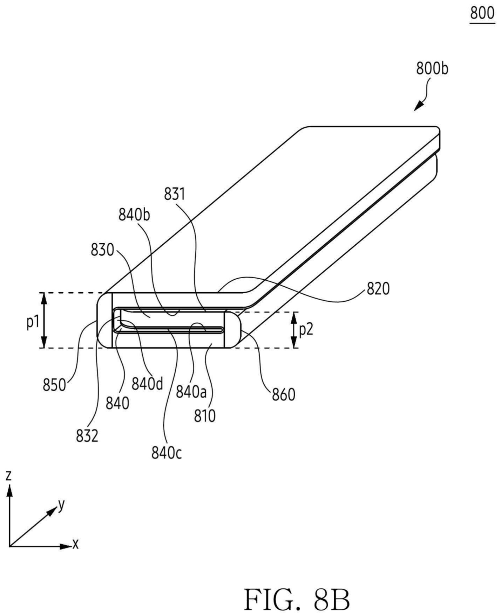

FIG. 8A illustrates an example of an unfolded state of an electronic device according to an embodiment. FIG. 8B illustrates an example of a fully folded state of an electronic device according to an embodiment.

Referring to FIG. 8A, an electronic device 800 may be unfolded in a first state 801a. The electronic device 800 may include a first housing 810, a second housing 820, and a third housing 830. The first housing 810 may include a first surface 810a. The second housing 820 may include a second surface 820a. The third housing 830 may include a third surface 830a. The first state 801a may be a state in which the first surface 810a, the second surface 820a, and the third surface 830a face substantially the same first direction (e.g., a z-axis direction). The first state 801a, which is a state in which the first housing 810, the second housing 820, and the third housing 830 are unfolded, may be referred to as an unfolded state. In the first state 801a, the first housing 810, the second housing 820, and the third housing 830 may form a substantially plane. For example, since the first housing 810, the second housing 820, and the third housing 830 substantially include a plane, the first surface 810a, the second surface 820a, and the third surface 830a may form the plane.

According to an embodiment, the electronic device 800 may include a first hinge structure 802 (802a and 802b) and a second hinge structure 803 (803a and 803b). The first hinge structure 802 may include a plurality of first hinge structures 802a and 802b. The second hinge structure 803 may include a plurality of second hinge structures 803a and 803b. The first hinge structures 802a and 802b may be disposed between the first housing 810 and the second housing 820. The first hinge structures 802a and 802b may rotatably connect the second housing 820 with respect to the first housing 810. For example, through the first hinge structures 802a and 802b, the second housing 820 may rotate with respect to the first housing 810 based on a first folding axis f3. Through the rotation of the second housing 820, a first angle Θ1 between the first housing 810 and the second housing 820 may be approximately 0° to 180°. The second hinge structures 803a and 803b may be disposed between the first housing 810 and the third housing 830. The second hinge structures 803a and 803b may rotatably connect the third housing 830 with respect to the first housing 810. For example, through the second hinge structures 803a and 803b, the third housing 830 may rotate with respect to the first housing 810 based on a second folding axis f4. Through the rotation of the third housing 830, a first angle Θ1 between the first housing 810 and the third housing 830 may be approximately 0° to 180°.

According to an embodiment, the first hinge structures 802a and 802b may be covered by a first hinge cover 850. One 802a of the first hinge structures 802a and 802b may be disposed at an end of the first hinge cover 850, and another one 802b may be disposed at another end of the first hinge cover 850. The second hinge structures 803a and 803b may be covered by a second hinge cover 860. One 803a of the second hinge structures 803a and 803b may be disposed at an end of the second hinge cover 860, and another one 803b may be disposed at another end of the second hinge cover 860.

According to an embodiment, the electronic device 800 may further include a display 500. The display 500 may be disposed on a surface formed by the first housing 810, the second housing 820, and the third housing 830. The display 500 may be disposed on the first surface 810a, the second surface 820a, and the third surface 830a. The display 500 may include a first display region 840a, a second display region 840b, and a third display region 840c. The first display region 840a may be disposed on the first surface 810a of the first housing 810. The first display region 840a may be a region that is not deformed by being coupled to the first surface 810a. The second display region 840b may be disposed on the second surface 820a of the second housing 820. The second display region 840b may be a region that is not deformed by being coupled to the second surface 820a. The third display region 840c may be disposed on the third surface 830a of the third housing 830. The third display region 840c may be a region that is not deformed by coupled to the third surface 830a. The first display region 840a, the second display region 840b, and the third display region 840c may be referred to as a planar region in terms of substantially forming a plane.

According to an embodiment, the display 500 may further include a fourth display region 840d and a fifth display region 840e. The fourth display region 840d may be disposed on the first hinge cover 850. The fourth display region 840d may be coupled to the first hinge cover 850 or the first hinge structures 802a and 802b. For example, the fourth display region 840d may be supported by a hinge plate (not illustrated) included in the first hinge structures 802a and 802b. The fourth display region 840d may be deformed as the second housing 820 rotates centered on the first folding axis f3 with respect to the first housing 810.

According to an embodiment, the fifth display region 840e may be disposed on the second hinge cover 860. The fifth display region 840e may be coupled to the second hinge cover 860 or the second hinge structures 803a and 803b. For example, the fifth display region 840e may be supported by a hinge plate (not illustrated) included in the second hinge structures 803a and 803b. The fifth display region 840e may be deformed as the third housing 830 rotates centered on the second folding axis f4 with respect to the first housing 810.

According to an embodiment, the fourth display region 840d may be larger than an area of the fifth display region 840e. For example, a first distance p1, which is a width of the fourth display region 840d, may be longer than a second distance p2, which is a width of the fifth display region 840e. When the electronic device 800 is converted into a folded state, a radius of curvature of the fourth display region 840d may be greater than a radius of curvature of the fifth display region 840e.

According to an embodiment, the electronic device 800 may further include first magnets 801a and 201b. The first magnets 810a and 810b may be disposed in the second housing 820. For example, the first magnets 810a may be disposed on a lateral surface of the second housing 820. The first magnets 810a may be disposed closer to another lateral surface facing a lateral surface than the lateral surface of the second housing 820 facing the first hinge cover 850. The first magnets 810a may at least partially overlap an inactive region disposed along a periphery of the second display region 840b, when the display 500 is viewed from above. The first magnets 801a and 201b may be disposed to face the second hinge structures 803a and 803b when the second housing 820 rotates and is folded along the first folding axis f3.

Referring to FIG. 8B, the electronic device 800 may be folded in a second state 801b. The second state 801b may be a state in which at least one surface among the first surface 810a, the second surface 820a, and the third surface 830a faces a different direction. The third display region 840c corresponding to the third surface 830a may face substantially the same direction as a direction (e.g., a -z-axis direction) in which the second display region 840b corresponding to the second surface 820a faces. The third display region 840c may face a direction different from a direction which the first display region 840a corresponding to the first surface 810a faces. For example, a direction (e.g., the -z-axis direction) in which the third display region 840c faces may be a direction opposite to a direction (e.g., a +z-axis direction) in which the first display region 840a faces. The third display region 840c may face the first display region 840a. The second state 801b may be referred to as a folded state in terms of a state in which the first housing 810, the second housing 820, and the third housing 30 are folded. In the second state 801b, the first housing 810, the second housing 820, and the third housing 830 may face each other. For example, in the second state 801b, the first housing 810, the third housing 830, and the second housing 820 may be stacked in a first direction (e.g., a z-axis direction).

According to an embodiment, the second housing 820 may rotate based on the first folding axis f3 with respect to the first housing 810 through the first hinge structure 802 while changing from the first state 801a to the second state 801b. In the second state 801b, the second housing 820 may face the third housing 830. For example, in the second state 801b, the second display region 840b disposed in the second housing 820 may face a rear surface 831 of the third housing 830.

According to an embodiment, the third housing 830 may rotate based on the second folding axis f4 with respect to the first housing 810 through the second hinge structure 803. In the second state 801b, the third housing 830 may face the first housing 810. For example, in the second state 801b, the third display region 840c disposed in the third housing 830 may face the first display region 840a disposed in the first housing 810. A lateral surface 832 of the third housing 830 may face the fourth display region 840d.

According to an embodiment, an overlapping area between the display 500 and the first hinge structure 802 when the first hinge cover 850 is viewed from above in the second state 801b may be wider than an overlapping area between the display 500 and the second hinge structure 803 when the second hinge cover 860 is viewed from above. A first distance p1, which is a width of the first hinge cover 850 corresponding to the fourth display region 840d, may be longer than a second distance p2, which is a width of the second hinge cover 860 corresponding to the fifth display region 840e (e.g., the fifth display region 840e of FIG. 11A). A difference between the first distance p1 and the second distance p2 may correspond to a thickness of the second housing 820.

According to an embodiment, based on the difference between the first distance p1 and the second distance p2, a housing that is foldable first among the second housing 820 and the third housing 830 may be determined. For example, the third housing 830 may first rotate based on the second folding axis f4 with respect to the first housing 810. After the third housing 830 is folded, the second housing 820 may rotate based on the first folding axis f3 with respect to the first housing 810. As a width of the second hinge structure 803 is narrower than a width of the first hinge structure 802, the third housing 830 may be folded to face the first housing 810. For example, as the width of the first hinge cover 850 is wider than the width of the second hinge cover 860, the third housing 830 may be folded to face the first housing 810 based on an operation of the second hinge structure 803 in the second hinge cover 860. As the width of the first hinge structure 802 is wider than the width of the second hinge structure 803, the second housing 820 may be folded to face the rear surface 831 of the third housing 830. For example, as the width of the first hinge cover 850 is wider than the width of the second hinge cover 860, the second housing 830 may be folded to face the rear surface 831 of the third housing 830 based on an operation of the first hinge structure 802 in the first hinge cover 850.

According to an embodiment, a first display part 510 may be disposed on at least one of the first surface 810a, the second surface 820a, and the third surface 830a. The first display part 510 may be aligned with at least one of the first surface 810a, the second surface 820a, and the third surface 830a. The first display part 510 may face at least one of the first surface 810a, the second surface 820a, and the third surface 830a. For example, the first display part 510 may include a plurality of first display parts aligned with the first surface 810a, the second surface 820a, and the third surface 830a.

According to an embodiment, a second display part 520 may be disposed on at least one of the first hinge structure 802 and the second hinge structure 803. The second display part 520 may be aligned with at least one of the first hinge structure 802 and the second hinge structure 803. The second display part 520 may face at least one of the first hinge structure 802 and the second hinge structure 803. For example, the second display part 520 may include a plurality of second display parts aligned with the first hinge structure 802 and the second hinge structure 803. For example, the second display part 520 may include the plurality of second display parts aligned with the fourth display region 840d and the fifth display region 840e.

In a case that a display is curved to have a different curvature for each of positions of the display, a strain of each of positions of the display may be different. Due to the difference in the strain, a magnitude of stress applied to each of the positions of the display may be different. An electronic device and/or the display may need a structure for reducing damage to the display due to the stress applied differently to each of positions of the display.

A display (e.g., the display 500 of FIGS. 4A and 4B) is provided. According to an embodiment, the display may comprise a first display part (e.g., the first display part 510 of FIGS. 4A and 4B). According to an embodiment, the display may comprise a second display part (e.g., the second display part 520 of FIGS. 4A and 4B) having a curved shape to have a curvature greater than the first display part. According to an embodiment, the display may comprise a plurality of pixels (e.g., the plurality of pixels 530 of FIG. 5A), spaced apart from each other, configured to emit light, and disposed in the first display part and the second display part. According to an embodiment, the display may comprise a plurality of connecting parts (e.g., the plurality of connecting parts 550 of FIG. 5A) connecting the plurality of pixels. According to an embodiment, the plurality of pixels may include a first pixel (e.g., the first pixel 531 of FIGS. 5A and 5B) and a second pixel (e.g., the second pixel 532 of FIGS. 5A and 5B) disposed in the first display part and respectively having a first size. According to an embodiment, it may include a third pixel (e.g., the third pixel 533 of FIGS. 5A and 5B) and a fourth pixel (e.g., the fourth pixel 534 of FIGS. 5A and 5B) disposed in the second display part and respectively having a second size smaller than the first size. According to an embodiment, the plurality of connecting parts may include at least one first connecting part (e.g., the first connecting part 551 of FIGS. 5A and 5B) having a first length and connecting the first pixel and the second pixel. According to an embodiment, it may include a plurality of second connecting parts (e.g., the plurality of second connecting parts 552 of FIGS. 5A and 5B) having a second length longer than the first length, having the number bigger than the number of the at least one first connecting part, and connecting the third pixel and the fourth pixel.

According to an embodiment, since the length of each of the plurality of second connecting parts disposed in the second display part having a relatively large curvature is longer than the length of the at least one first connecting part, the display may provide a structure that is robust against damage.

According to an embodiment, a cross-sectional area of each of the plurality of second connecting parts may be smaller than a cross-sectional area of the at least one first connecting part.

According to an embodiment, since the cross-sectional area of each of the plurality of second connecting parts disposed in the second display part having a relatively large curvature is smaller than the cross-sectional area of the at least one first connecting part, the display may provide a structure in which a resistance value of the plurality of second connecting parts is substantially equal to a resistance value of the at least one first connecting part.

According to an embodiment, a sum of the cross-sectional area of each of the plurality of second connecting parts may be larger than the cross-sectional area of the at least one first connecting part.

According to an embodiment, since the sum of the cross-sectional area of each of the plurality of second connecting parts disposed in the second display part having a relatively large curvature is smaller than the cross-sectional area of the at least one first connecting part, the display may provide a structure in which a resistance value of the plurality of second connecting parts is substantially equal to a resistance value of the at least one first connecting part.

According to an embodiment, a resistance value of the at least one first connecting part may be equal to a resistance value of the plurality of second connecting parts.

According to an embodiment, since the resistance value of the plurality of second connecting parts is substantially equal to the resistance value of the at least one first connecting part, the display may provide a structure capable of smoothly controlling the plurality of pixels.

According to an embodiment, linear distances between centers of each of the plurality of pixels may be same each other.

According to an embodiment, since the linear distances between the centers of each of the plurality of pixels are same each other, the display may provide a structure in which PPI in the first display part and the second display part may be maintained substantially constant.

According to an embodiment, each of the plurality of connecting parts may include a connecting line electrically connecting the plurality of pixels.

According to an embodiment, each of the plurality of connecting parts may have a curved shape between the plurality of pixels.

According to an embodiment, since each of the plurality of connecting parts has the curved shape, the display may provide a structure in which stress generated as the display is bent may be reduced.

According to an embodiment, each of the plurality of connecting parts may have a serpentine shape.

According to an embodiment, since each of the plurality of connecting parts may have the serpentine shape, the display may provide a structure in which stress generated as the display is bent may be reduced.

According to an embodiment, when the display is viewed from above, an area of the first pixel may be bigger than an area of the third pixel.

According to an embodiment, since the first pixel and the third pixel have different sizes, the display may provide a structure in which a distance between pixels may be maintained.

According to an embodiment, the second display part may be disposed along a periphery of the first display part.

According to an embodiment, the second display part may surround the first display part.

According to an embodiment, a curvature of the first display part may be changed according to a position of the first display part. According to an embodiment, a curvature of the second display part may be changed according to a position of the second display part.

According to an embodiment, a strain of the first display part may be smaller than a strain of the second display part.

According to an embodiment, the first pixel may include a plurality of first sub-pixels (e.g., the plurality of first sub-pixels 531a, 531b, 531c, and 531d of FIG. 5B). According to an embodiment, the third pixel may include a plurality of second sub-pixels (e.g., the plurality of second sub-pixels 532a, 532b, 532c, and 532d of FIG. 5B) having a size smaller than a size of the plurality of first sub-pixels.

According to an embodiment, the plurality of connecting parts may include a plurality of third connecting parts (e.g., a plurality of third connecting parts 553 of FIGS. 5A and 5B) having the second length and connecting the second pixel and the third pixel.

An electronic device (e.g., the electronic device 400 of FIGS. 4A and 4B) is provided. According to an embodiment, the electronic device may comprise a frame (e.g., the frame 410 of FIGS. 4A and 4B). According to an embodiment, the electronic device may comprise a display (e.g., the display 500 of FIGS. 4A and 4B) disposed on the frame. According to an embodiment, the display may include a first display part (e.g., the first display part 510 of FIGS. 4A and 4B). According to an embodiment, the display may include a second display part (e.g., the second display part 520 of FIGS. 4A and 4B) having a curved shape to have a curvature greater than the first display part. According to an embodiment, the display may include a plurality of pixels (e.g., the plurality of pixels 530 of FIG. 5A) respectively configured to emit light, disposed in the first display part and the second display part and spaced apart from each other. According to an embodiment, the display may include a plurality of connecting parts (e.g., the plurality of connecting parts 550 of FIG. 5A) connecting the plurality of pixels and having a curved shape. According to an embodiment, the plurality of pixels may include a first pixel (e.g., the first pixel 531 of FIGS. 5A and 5B) and a second pixels (e.g., the second pixel 532 of FIGS. 5A and 5B) disposed in the first display part and respectively having a first size. According to an embodiment, the plurality of pixels may include a third pixel (e.g., the third pixel 533 of FIGS. 5A and 5B) and a fourth pixel (e.g., the fourth pixel 534 of FIGS. 5A and 5B) disposed in the second display part and respectively having a second size smaller than the first size. According to an embodiment, the plurality of connecting parts may include at least one first connecting part (e.g., the first connecting part 551 of FIGS. 5A and 5B) having a first length and connecting the first pixel and the second pixel. According to an embodiment, the plurality of connecting parts may include a plurality of second connecting parts (e.g., the plurality of second connecting parts 552 of FIGS. 5A and 5B) having a second length longer than the first length, connecting the third pixel and the fourth pixel.

According to an embodiment, since the length of each of the plurality of second connecting parts disposed in the second display part having a relatively large curvature is longer than the length of the at least one first connecting part, the display may provide a structure that is robust against damage.

According to an embodiment, a cross-sectional area of each of the plurality of second connecting parts may be smaller than a cross-sectional area of the at least one first connecting part.

According to an embodiment, a distance between the first pixel and the second pixel may be equal to a distance between the third pixel and the fourth pixel.

According to an embodiment, since the linear distances between the centers of each of the plurality of pixels are same each other, the display may provide a structure in which PPI in the first display part and the second display part may be maintained substantially constant.

According to an embodiment, a sum of the cross-sectional area of each of the plurality of second connecting parts may be larger than the cross-sectional area of the at least one first connecting part.

According to an embodiment, since the sum of the cross-sectional area of each of the plurality of second connecting parts disposed in the second display part having a relatively large curvature is smaller than the cross-sectional area of the at least one first connecting part, the display may provide a structure in which a resistance value of the plurality of second connecting parts is substantially equal to a resistance value of the at least one first connecting part.

According to an embodiment, a resistance value of the at least one first connecting part may be equal to a resistance value of the plurality of second connecting parts.

According to an embodiment, since the resistance value of the plurality of second connecting parts is substantially equal to the resistance value of the at least one first connecting part, the display may provide a structure capable of smoothly controlling the plurality of pixels.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. **In** such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display (500) comprising:
a first display part (510);
a second display part (520) having a curved shape to have a curvature greater than the first display part (510);
a plurality of pixels (530), spaced apart from each other, configured to emit light, and disposed in the first display part (510) and the second display part (520); and
a plurality of connecting parts (550) connecting the plurality of pixels (530),
wherein, the plurality of pixels (530) includes:
a first pixel (531) and a second pixel (532) disposed in the first display part (510) and respectively having a first size; and
a third pixel (533) and a fourth pixel (534) disposed in the second display part (520) and respectively having a second size smaller than the first size, and
wherein the plurality of connecting parts (550) includes:
at least one first connecting part (551) having a first length and connecting the first pixel (531) and the second pixel (532); and
a plurality of second connecting parts (552) having a second length longer than the first length, and connecting the third pixel (533) and the fourth pixel (534).

2. The display (500) of claim 1,
wherein a cross-sectional area of each of the plurality of second connecting parts (552) is smaller than a cross-sectional area of the at least one first connecting part (551).

3. The display (500) of claim 2,
wherein a sum of the cross-sectional area of each of the plurality of second connecting parts (552) is larger than the cross-sectional area of the at least one first connecting part (551).

4. The display (500) of claim according to any one claims 1 to 3,
wherein a resistance value of the at least one first connecting part (551) is equal to a resistance value of the plurality of second connecting parts (552).

5. The display (500) of claim according to any one claims 1 to 4,
wherein a linear distance between centers of each of the plurality of pixels (530) are same each other.

6. The display (500) of claim according to any one claims 1 to 5,
wherein each of the plurality of connecting parts (550) further includes a connecting line electrically connecting the plurality of pixels (530).

7. The display (500) of claim according to any one claims 1 to 6,
wherein each of the plurality of connecting parts (550) has a curved shape between the plurality of pixels (530).

8. The display (500) of claim according to any one claims 1 to 7,
wherein each of the plurality of connecting parts (550) has a serpentine shape.

9. The display (500) of claim according to any one claims 1 to 8,
wherein the number of the plurality of second connecting parts (552) is bigger than the number of the at least one first connecting part (551).

10. The display (500) of claim according to any one claims 1 to 9,
wherein the second display part (520) is disposed along a periphery of the first display part (510).

11. The display (500) of claim 10,
wherein the second display part (520) surrounds the first display part (510).

12. The display (500) of claim according to any one claims 1 to 11,
wherein a curvature of the first display part (510) is changed according to a position of the first display part (510), and
wherein a curvature of the second display part (520) is changed according to a position of the second display part (520).

13. The display (500) of claim according to any one claims 1 to 12,
wherein a strain of the first display part (510) is smaller than a strain of the second display part (520).

14. The display (500) of claim according to any one claims 1 to 13,
wherein the first pixel (531) includes a plurality of first sub-pixels, and
wherein the third pixel (533) includes a plurality of second sub-pixels having a size smaller than a size of the plurality of first sub-pixels.

15. The display (500) of claim according to any one claims 1 to 14,
wherein the plurality of connecting parts (550) further includes a plurality of third connecting parts (553) respectively having the second length and connecting the second pixel (532) and the third pixel (533).
